# EUROPEAN PATENT APPLICATION

(11) **EP 2 587 524 A1**
(43) Date of publication of application: **01.05.2013**
(21) Application number: 11798103.5
(22) Date of filing: 20.06.2011
(51) Int. Cl.: H01L 21/205, C23C 16/455

(54) **VAPOR DEPOSITION APPARATUS**

(30) Priority: 26.01.2011 JP 2011013969; 23.06.2010 JP 2010142129
(71) Applicant: Sharp Kabushiki Kaisha, Osaka-shi, Osaka 545-8522 (JP)
(72) Inventor: WAKASA, Kanako, Osaka 545-8522 (JP); SAKAGAMI, Hidekazu, Osaka 545-8522 (JP); TSUBOI, Toshiki, Osaka 545-8522 (JP)
(74) Representative: Müller - Hoffmann & Partner
(86) International application number: PCT/JP2011/064084
(87) International publication number: WO 2011/162219

(57) **Abstract**

Disclosed is a vapor deposition apparatus (1A), comprising: a reactor (20) for housing a target substrate (31) on which a thin film is to be formed by vapor deposition; a shower head (10) having: a gas inlet (14) for introducing a gas; a gas distribution space (13) for diffusing the gas; and a shower plate (11) having a plurality of gas channels (15) for supplying the gas from the gas distribution space (13) into the reactor (20); and a gas outlet (26) for externally discharging the gas from the reactor (20), the gas distribution space (13) of the shower head (10) having the shower plate (11) as a bottom face thereof, the gas distribution space (13) having a first space (131) located relatively far from the gas outlet (26) of the reactor (20) and a second space (132) located relatively close to the gas outlet (26) of the reactor (20), the first space (131) being formed so as to be taller than the second space (132).

## Description

### Technical Field

The present invention relates to a vapor deposition apparatus for use in, for example, vertical shower head MOCVD (metal organic chemical vapor deposition)

### Background Art

MOCVD technology and apparatus (vapor deposition apparatus) has been conventionally used in the manufacture of light-emitting diodes and semiconductor laser devices. MOCVD grows crystals of compound semiconductor material by supplying, to a reaction chamber, an organic metal gas (e.g., trimethylgallium (TMG) or trimethylaluminum (TMA)) and a hydride gas (e.g., ammonia (NH₃), phosphine (PH₃), or arsine (AsH₃)) as source gases which contribute to film formation.

In MOCVD, source gases (an organic metal gas and a hydride gas) are supplied together with an inert gas, such as hydrogen or nitrogen, to a reaction chamber. The gaseous mixture is then heated so that it reacts on a predetermined target substrate to grow crystals of compound semiconductor material on the target substrate. A requirement in the manufacture of crystals of compound semiconductor material by MOCVD is to ensure a maximum yield and productivity while improving the quality of the grown compound semiconductor crystals, all in a cost effective manner.

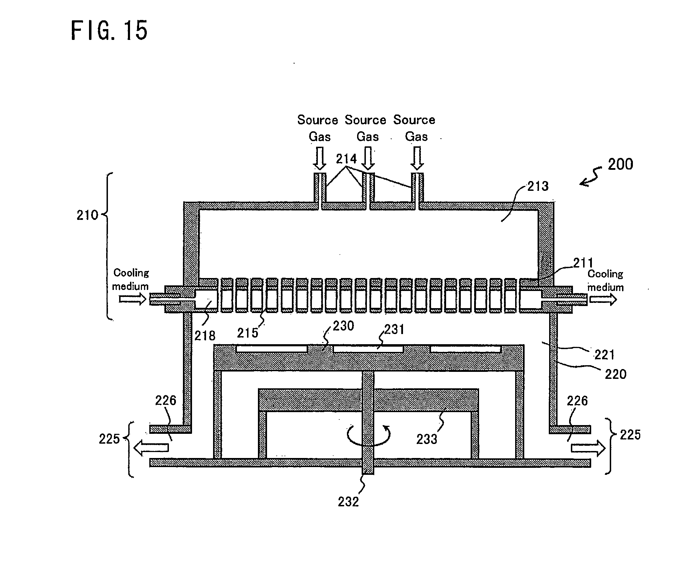

Fig. 15 illustrates a configuration of a conventional general vertical shower head MOCVD apparatus (hereinafter, will be referred to as "vapor deposition apparatus") used in MOCVD. A vapor deposition apparatus 200, as illustrated in Fig. 15, is provided with a substantially cylindrical shower head 210 for supplying a source gas introduced through gas inlets 214 to a reaction chamber 221 inside a reactor 220.

The shower head 210 includes: the gas inlets 214 through which a source gas is introduced; a gas distribution space 213 for uniformly and broadly diffusing the source gas introduced through the gas inlets 214; and a shower plate 211, having, at predetermined intervals therein, gas channels 215 for supplying the source gas diffused in the gas distribution space 213 to the reaction chamber 221. The shower head 210 also includes a cooling medium channel 218 around the gas channels 215. A cooling medium flows in the cooling medium channel 218 so as to regulate the temperature of the gas channels 215.

A rotation axis 232 is provided in a lower central part of the reaction chamber 221 and supported by an actuator (not shown) so as to be freely rotatable. On the tip of the rotation axis 232 is there attached a disc-shaped substrate support 230 on which a target substrate 231 is placed opposite a face of the shower plate 211 from which the source gas is supplied. A heater 233 for heating the substrate support 230 is attached below the substrate support 230. A gas discharge section 225, including gas outlets 226 for externally discharging the gas in the reaction chamber 221, is provided in a lower part of the reactor 220.

To grow crystals of compound semiconductor material on the target substrate 231 by using the vapor deposition apparatus 200 thus configured, the target substrate 231 is placed on the substrate support 230, followed by the rotation of the substrate support 230 driven by the rotation of the rotation axis 232. Next, the target substrate 231 is heated to a predetermined temperature by the heater 233 via the substrate support 230. Under these conditions, the source gas is supplied from the gas channels 215 penetrating through the shower plate 211 to the reaction chamber 221 inside the reactor 220. The source gas thus supplied is heated by the heat of target substrate 231 and undergoes chemical reactions to grow semiconductor crystalline films on the target substrate 231.

To supply two or more source gases to grow crystals of compound semiconductor material on the target substrate 231, the source gases are introduced through different gas inlets 214 and mixed in the gas distribution space 213 of the shower head 210. The mixed gas is supplied from the gas channels 215 penetrating through the shower plate 211 to the reaction chamber 221 inside the reactor 220.

The vapor deposition apparatus of this type is required to create a uniform gas flow rate, gas mix ratio, etc. across all the gas channels so that the film can be formed with a uniform thickness, composition ratio, etc. across the entire surface of the target substrate.

To respond to this requirement, for example, Patent Literature 1 discloses a vacuum manufacturing device in which a gas supplied from a plurality of gas supply systems each provided with an independent mass flow controller (flow rate adjusting section) is passed through gas spaces, one being provided for each gas supply system, before being fed into the vacuum chamber. The vacuum manufacturing device is capable of adjusting the gas flow rate for the individual gas supply systems. The device is therefore capable of forming a film with a uniform thickness across the entire surface of the target substrate.

As another example, Patent Literature 2 discloses a semiconductor manufacturing device including a shower head provided with a plurality of gas ejection holes to supply a gas to the surface of a target substrate, the shower head being divided radially from its center into a plurality of blocks so that the gas flow rate can be controlled independently in each block. The semiconductor manufacturing device is capable of adjusting the distribution of gas concentration block by block. The device is therefore capable of forming a film with a uniform thickness across the entire surface of the target substrate.

Patent Literature 2 also discloses a semiconductor manufacturing device including a shower head provided with a plurality of gas ejection holes to supply a gas to the surface of a target substrate, the device having a face, opposite the gas ejection holes, which has holes at corresponding parts of the face so that stoppers for the gas ejection holes can be inserted in the holes. The semiconductor manufacturing device is capable of adjusting the distribution of gas concentration by selectively opening gas ejection holes to enable gas supply to the surface of the target substrate and inserting stoppers to stop the gas supply. The device is therefore capable of forming a film with a uniform thickness across the entire surface of the target substrate.

Patent Literature 2 further discloses a semiconductor manufacturing device including a shower head provided with an umbrella-shaped gas ejection face which is separated from the surface of a target substrate by a distance which gradually decreases farther away from the center of the face toward the periphery. The semiconductor manufacturing device restrains increases of gas passage area which could occur with increasing distance from the center toward the periphery. The device is therefore capable of forming a film with a uniform thickness across the entire surface of the target substrate.

### Citation List

### Patent Literature

Patent Literature 1
   Japanese Patent Application Publication, Tokukai, No. 2000-294538A (Published October 20, 2000)
Patent Literature 2
   Japanese Patent Application Publication, Tokukai, No. 2003-309075A (Published October 31, 2003)

### Summary of Invention

### Technical Problem

The vapor deposition apparatus 200, illustrated in Fig. 15, is provided, in a side wall of the reactor 220, with the gas outlets 226 for externally discharging the gas introduced. Under the effect of the discharge gas flow to the gas outlets 226, the flow rate is higher for the gas supplied from those gas channels 215 which are close to the gas outlets 226 than for the gas supplied from those gas channels 215 which are far from the gas outlets 226 (near the center). In other words, the larger the gas supply region which is substantially identical to a region where a film is to be formed, the larger the difference between the maximum and minimum flow rates for the gas supplied from the gas channels 215 which are located in the gas supply region, and the larger the difficulty in forming the film with a uniform thickness.

For these reasons, in the vacuum manufacturing device of Patent Literature 1 and the semiconductor manufacturing device of Patent Literature 2, the region where a film is to be formed is divided into a plurality of subregions in each of which a film can be formed with a uniform thickness, and each subregion is provided with an independent gas supply system, so that the flow rate can be adjusted individually for each gas supply system.

Meanwhile, for example, a large-capacity vapor deposition apparatus which forms a film on multiple 6-inch substrates in a single batch is required to form a film covering an area as large as about ϕ = 600 mm with a uniform thickness. If the large-capacity vapor deposition apparatus is configured so that a region thereof where a film is to be formed is divided into a plurality of subregions, the subregions are too numerous to implement a simple design because the same number of mass flow controllers (flow rate adjusting sections) and piping system members as the subregions are needed.

As mentioned above, Patent Literature 2 discloses a semiconductor manufacturing device capable of selectively opening each gas ejection hole to enable gas supply and inserting a stopper to stop the gas supply. A large-capacity vapor deposition apparatus would, however, need more than a few thousand gas ejection holes. It is therefore complex and laborious to determine, for each one of the gas ejection holes, whether it should be opened or closed by inserting a stopper, so that a film can be formed with a uniform thickness across the entire surface of the target substrate.

Patent Literature 2, as mentioned above, also discloses a semiconductor manufacturing device including a shower head provided with an umbrella-shaped gas ejection face which is separated from the surface of the target substrate by a distance which gradually decreases from the center of the face toward the periphery. Advanced fabrication technology is necessary, however, to enable symmetric fabrication while maintaining a desired inclination angle. Especially, for a large-capacity vapor deposition apparatus, the shower head has a large gas ejection face to be fabricated. It is thus extremely difficult to fabricate the gas ejection face of the shower head in an umbrella-like shape so that a film can be formed with a uniform thickness across the entire surface of the target substrate.

The present invention, conceived in view of these problems, has an object of providing a vapor deposition apparatus which is simple and convenient to design and assemble and allows for quality improvement in terms of the thickness, composition ratio, etc. of a film formed on a target substrate by supplying gas more uniformly in amount on the surface of a target substrate in a reaction chamber.

### Solution to Problem

To attain the object, the vapor deposition apparatus in accordance with the present invention includes: a reactor for housing a target substrate on which a thin film is to be formed by vapor deposition; a shower head having: a gas inlet for introducing a gas; a gas distribution space for diffusing the gas; and a shower plate having a plurality of gas channels for supplying the gas from the gas distribution space into the reactor; and a gas outlet for externally discharging the gas from the reactor, the gas distribution space of the shower head having the shower plate as a bottom face thereof, the gas distribution space having a first space and a second space, the first space being farther from the gas outlet of the reactor than is the second space, the first space being formed so as to be taller than the second space.

According to the invention, in the gas distribution space of the shower head, the first space, which is located relatively far from the gas outlet, is formed so as to be taller than the second space, which is located relatively close to the gas outlet. In other words, the present invention makes it possible to supply gas uniformly in amounton the surface of the target substrate in the reaction chamber by the structural shape of the gas distribution space. This in turn improves quality of the film formed on the target substrate in terms of its thickness, composition ratio, etc. Hence, the invention can provide a vapor deposition apparatus at low design and assembly cost.

### Advantageous Effects of Invention

The vapor deposition apparatus in accordance with the present invention, as described in the foregoing, is such that the gas distribution space of the shower head has the shower plate as a bottom face thereof and is provided with a first space and a second space, the first space being farther from the gas outlet of the reactor than is the second space, and also that the first space is formed so as to be taller than the second space.

The invention advantageously provides a vapor deposition apparatus which is simple and convenient to design and assemble and allows for quality improvement in terms of the thickness, composition ratio, etc. of a film formed on a target substrate by supplying gas uniformly in amount on the surface of a target substrate in a reaction chamber.

### Brief Description of Drawings

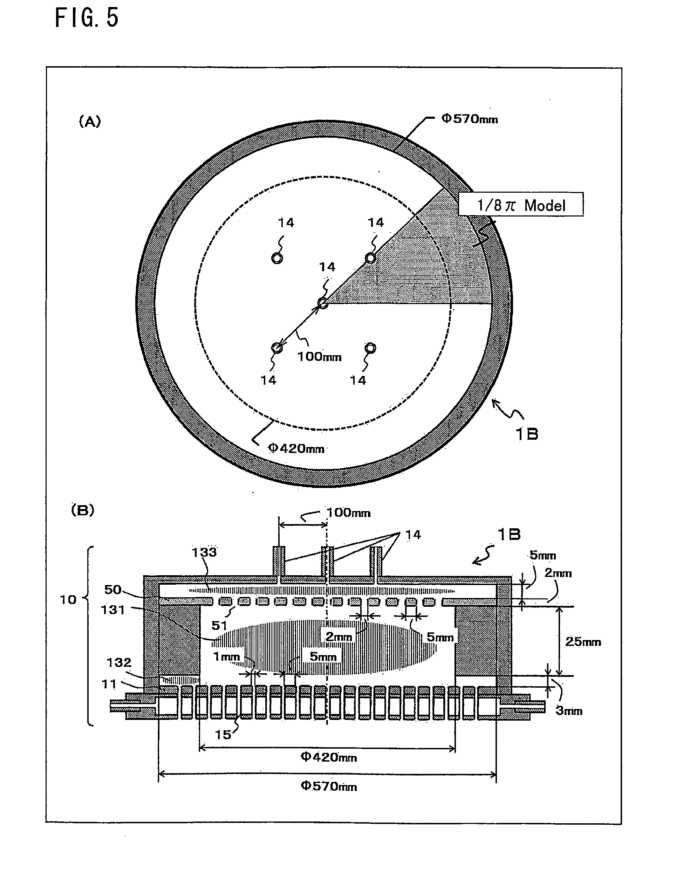

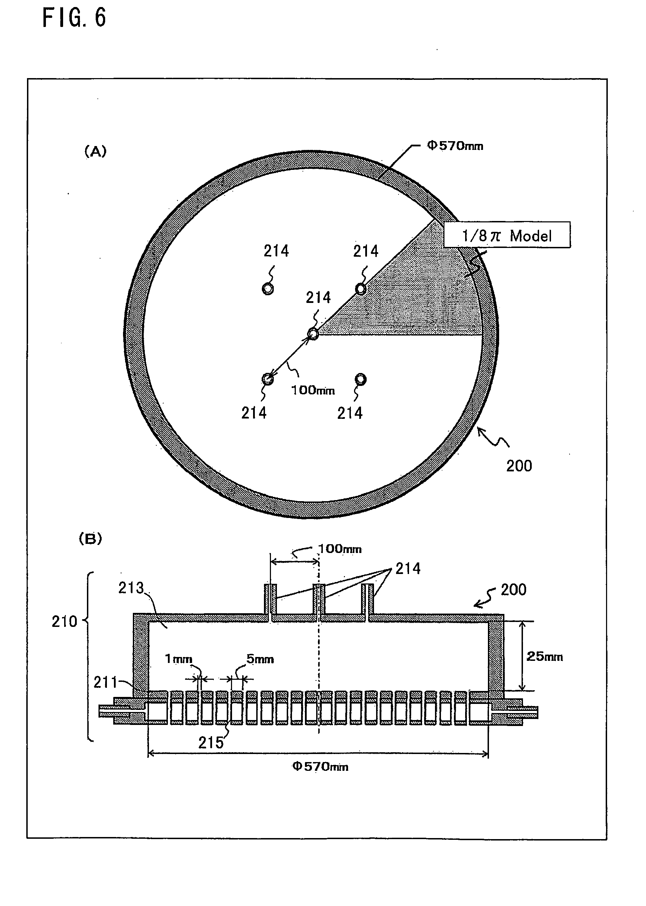

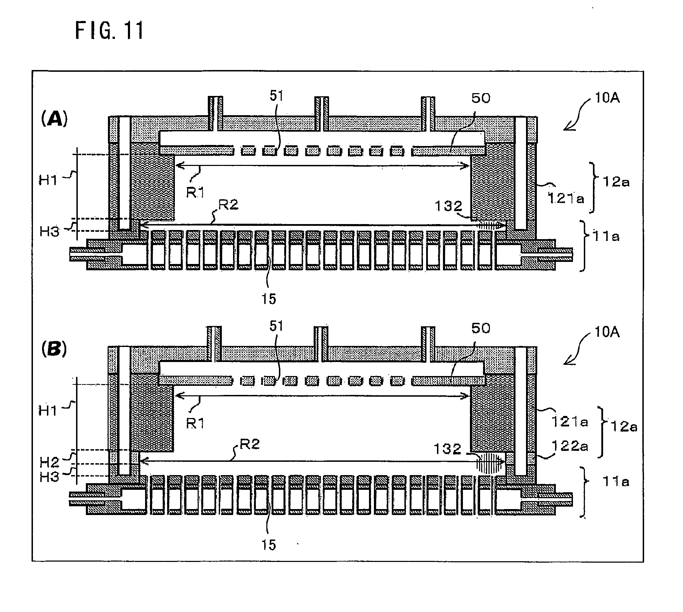

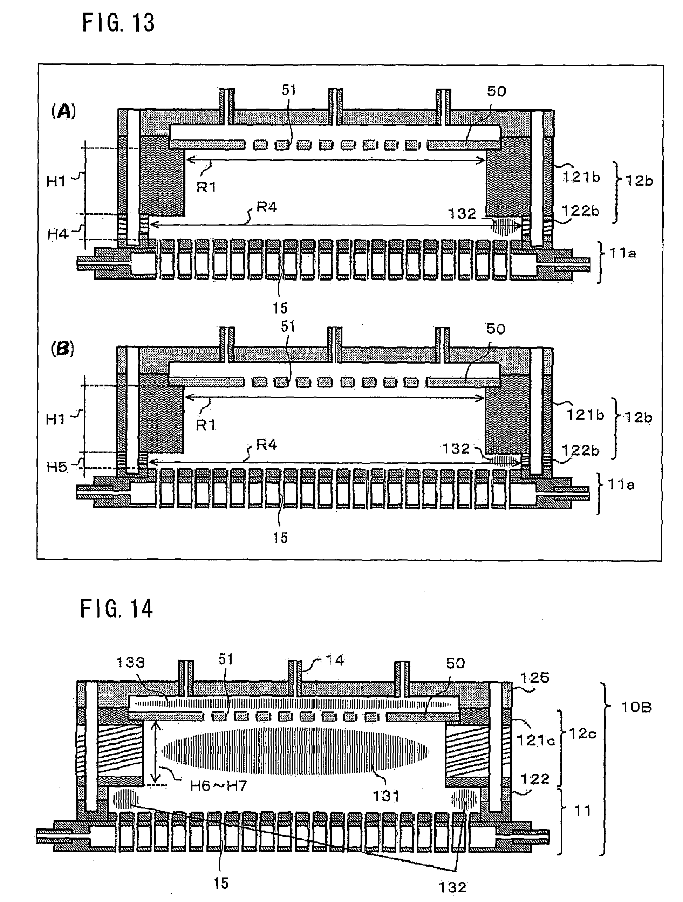

Fig. 1

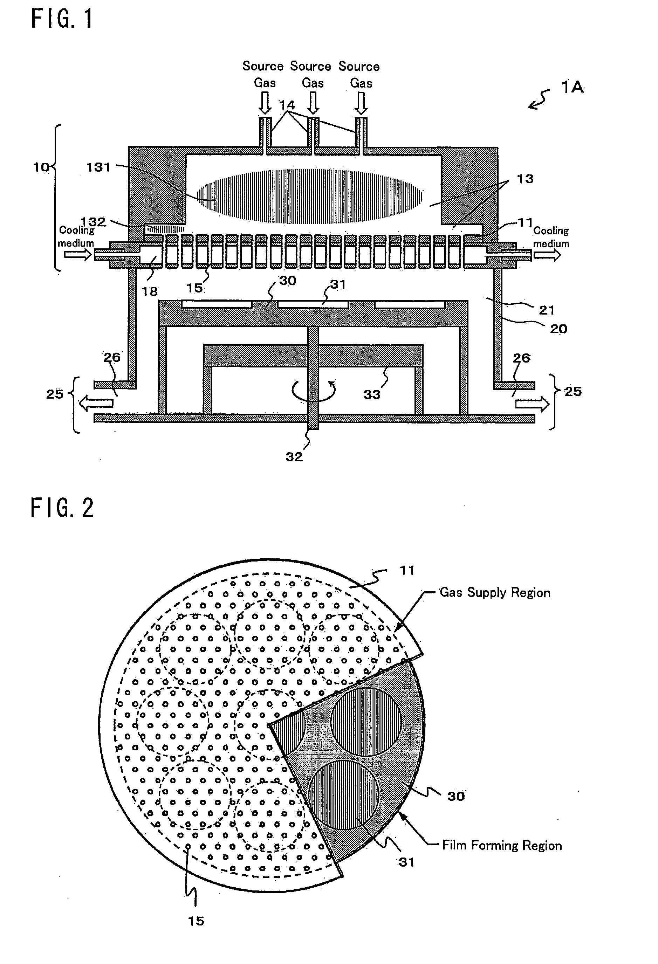

   Fig. 1, illustrating embodiment 1 of the vapor deposition apparatus in accordance with the present invention, is a cross-sectional view of the vapor deposition apparatus.
Fig. 2
   Fig. 2 is a plan view illustrating relative positions of a shower plate and a substrate support in the vapor deposition apparatus.
Fig. 3

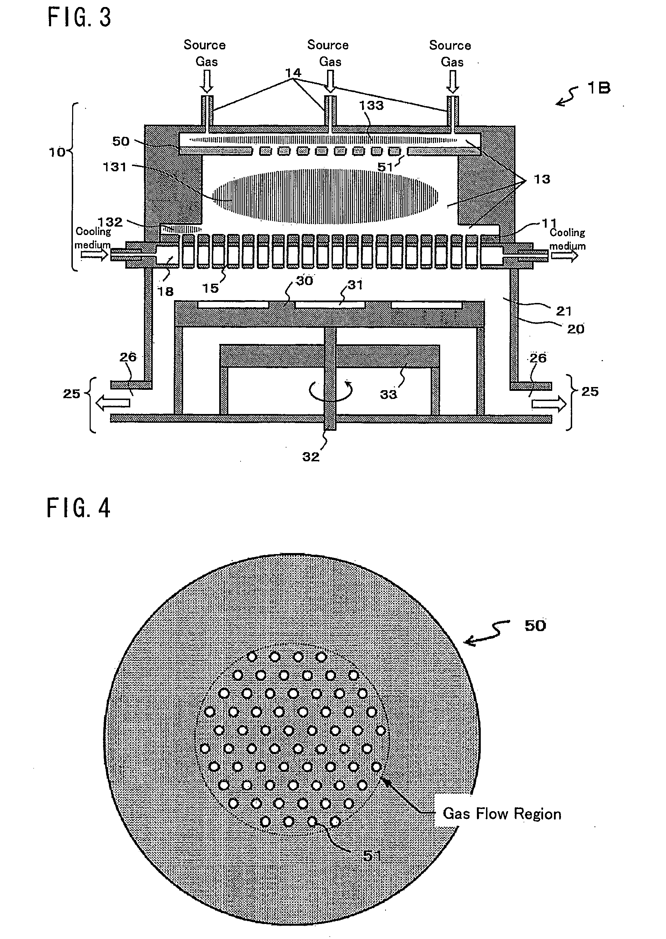

   Fig. 3, illustrating embodiment 2 of the vapor deposition apparatus in accordance with the present invention, is a cross-sectional view of the vapor deposition apparatus.
Fig. 4
   Fig. 4 is a plan view illustrating the configuration of a diffusion plate in the vapor deposition apparatus.
Fig. 5
   (A) and (B) of Fig. 5 are drawings illustrating a vapor deposition apparatus model used in a simulation of gas flow rate distribution.
Fig. 6
   (A) and (B) of Fig. 6 are drawings illustrating a conventional vapor deposition apparatus model used in a simulation of gas flow rate distribution.
Fig. 7

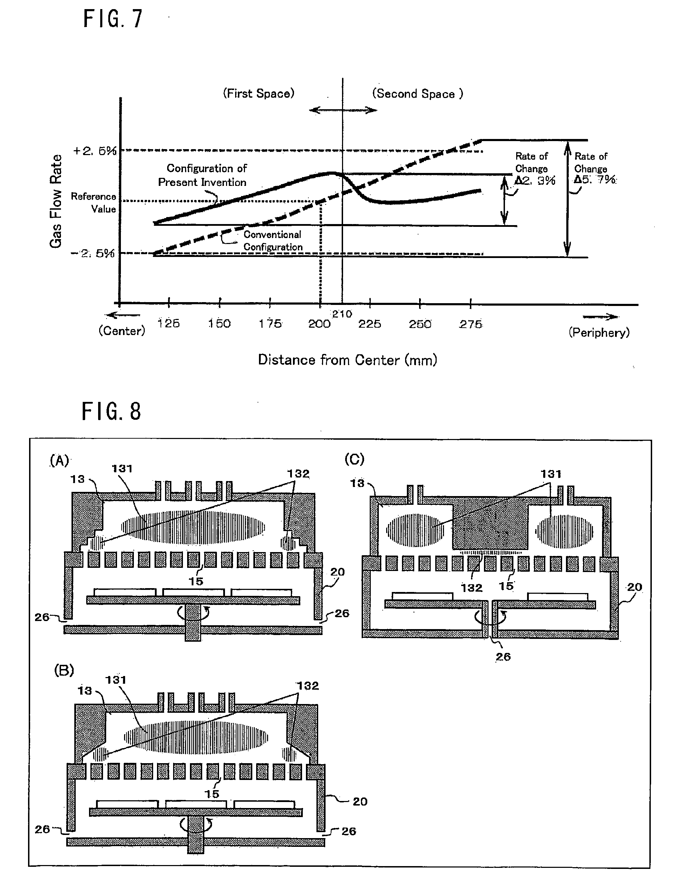

   Fig. 7 is a graphical representation of gas flow rate distribution for the vapor deposition apparatus model and the conventional vapor deposition apparatus model.
Fig. 8
   (A), (B), and (C) of Fig. 8 are drawings illustrating the cross-sectional shapes of exemplary gas distribution spaces which are applicable to a vapor deposition apparatus in accordance with one embodiment.
Fig. 9

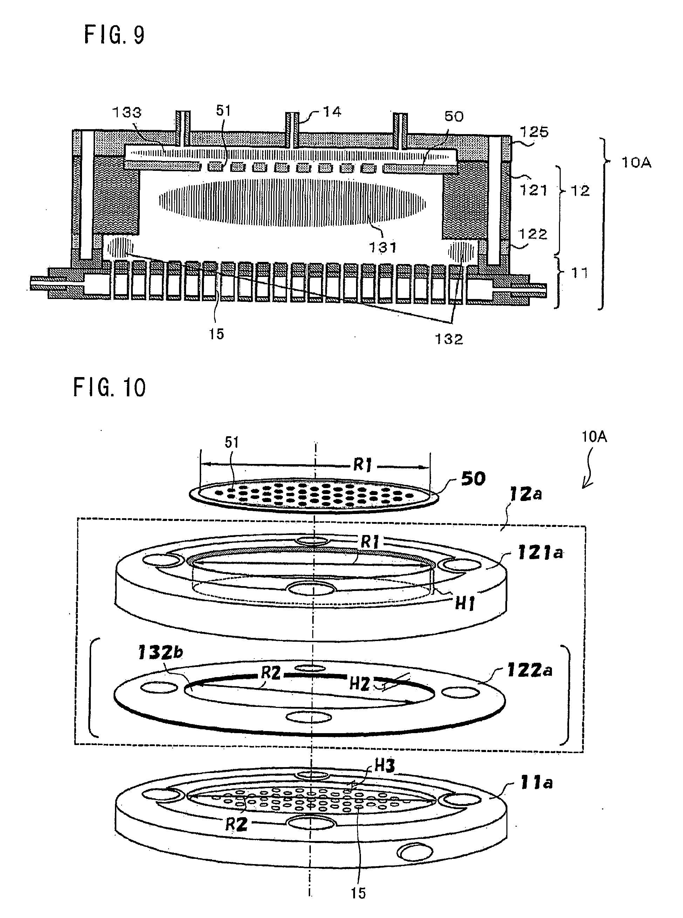

   Fig. 9, illustrating embodiment 3 of the vapor deposition apparatus in accordance with the present invention, is a cross-sectional view of a schematic configuration of a shower head in the vapor deposition apparatus.
Fig. 10
   Fig. 10 is an exploded perspective view of the configuration of a first group of members of a shower head in the vapor deposition apparatus.
Fig. 11
   (A) and (B) of Fig. 11 are cross-sectional views of the configuration of a second space formed by the first group of members in the vapor deposition apparatus.
Fig. 12

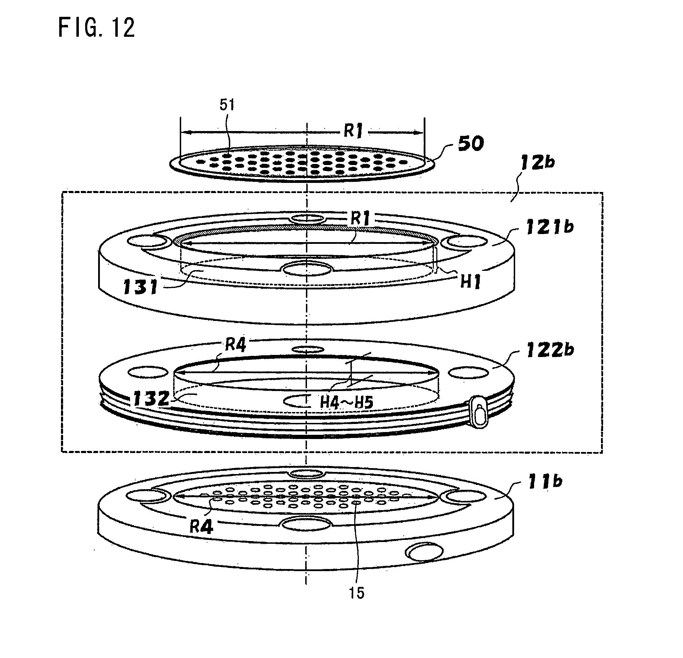

   Fig. 12 is an exploded perspective view of the configuration of a second group of members of a shower head in the vapor deposition apparatus.
Fig. 13
   (A) and (B) of Fig. 13 are cross-sectional views of the configuration of a second space formed by the second group of members in the vapor deposition apparatus.
Fig. 14
   Fig. 14, illustrating embodiment 4 of the vapor deposition apparatus in accordance with the present invention, is a cross-sectional view of a schematic configuration of a shower head in the vapor deposition apparatus.
Fig. 15
   Fig. 15 is a cross-sectional view of the configuration of a conventional vapor deposition apparatus.

### Description of Embodiments

### [Embodiment 1]

The following will describe an embodiment of the present invention in reference to Figs. 1 and 2.

A vapor deposition apparatus 1A in accordance with the present embodiment is described in reference to Fig. 1. Fig. 1 is a cross-sectional view of the configuration of the vapor deposition apparatus 1A in accordance with the present embodiment.

The vapor deposition apparatus 1A, as illustrated in Fig. 1, is provided with a substantially cylindrical shower head 10 for supplying a source gas introduced through gas inlets 14 to a reaction chamber 21 inside a reactor 20.

The shower head 10 includes: the gas inlets 14 through which a source gas is introduced; a gas distribution space 13 for uniformly and broadly diffusing the source gas introduced through the gas inlets 14; and a shower plate 11 for supplying the source gas diffused in the gas distribution space 13 to the reaction chamber 21. The shower head 10 also includes a cooling medium channel 18 around gas channels 15 formed in the shower plate 11. A cooling medium flows in the cooling medium channel 18 so as to regulate the temperature of the gas channels 15.

A rotation axis 32 is provided in a lower central part of the reaction chamber 21 and supported by an actuator (not shown) so as to be freely rotatable. On the tip of the rotation axis 32 is there attached a disc-shaped substrate support 30 on which a target substrate 31 is placed opposite a face of the shower plate 11 from which the source gas is supplied. A heater 33 for heating the substrate support 30 is attached below the substrate support 30. A gas discharge section 25, including gas outlets 26 for externally discharging the gas in the reaction chamber 21, is provided in a lower part of the reactor 20.

The gas distribution space 13 of the vapor deposition apparatus 1A is, as illustrated in Fig. 1, divided into a first space 131 located near the center thereof and a second space 132 located near the periphery. The second space 132 has a height (measured from its floor face to its ceiling face) which is smaller than that of the first space 131 (measured from its floor face to its ceiling face) (this shape will be hereinafter referred to as a "hat-like shape"). Specifically, there is provided a step between the side wall of the first space 131 and the side wall of the second space 132.

In other words, in the present embodiment, the gas distribution space 13 includes the first space 131 located relatively far from the gas outlets 26 of the reactor 20 and the second space 132 located relatively close to the gas outlets 26 of the reactor 20. Additionally, the first space 131 is formed so as to be taller than the second space 132.

Next, the configuration of the shower plate 11 is described in reference to Fig. 2. Fig. 2 is a plan view illustrating relative positions of the shower plate 11, the gas channels 15 penetrating through the shower plate 11, the substrate support 30, and the target substrate 31 placed on the substrate support 30.

The vapor deposition apparatus 1A, as illustrated in Fig. 2, is a large-capacity vapor deposition apparatus capable of forming a film on nine target substrates 31 (eight along the circumference and another one at the center) which are placed on the substrate support 30. The shower plate 11 has the plurality of gas channels 15 with a predetermined diameter at predetermined intervals in a region (gas supply region) of the face, of the shower plate 11, where the source gas is supplied, the gas supply region being opposite the entire face (film forming region) of the substrate support 30 on which the target substrate 31 is placed. When the target substrate 31 is, for example, a 6-inch or greater large-size substrate, the film forming region and the gas supply region have a ϕ (diameter) of about 600 mm.

The gas supply rates from the gas channels 15 penetrating through the shower plate 11 vary slightly from one gas channel 15 to another under these conditions, due to the effect of the discharge gas flow to the gas outlets 26. Specifically, the gas supply rates from those gas channels 15 which are close to the gas outlets 26 and near the periphery are a maximum, and the gas supply rates from those gas channels 15 which are far from the gas outlets 26 and near the center are a minimum.

The vertical dimensions of the device members, such as the heater 33, which are provided inside the reaction chamber 21 may be roughly equal to those in the case of a compact vapor deposition apparatus. In other words, when these device member are disposed in the reaction chamber 21, the vertical distance from the source gas supply face of the shower plate 11 to the gas outlets 26 does not need to be larger than the corresponding distance in the case of a compact vapor deposition apparatus.

As mentioned earlier, undesirably, in the large-capacity vapor deposition apparatus 1A in which the film forming region and the gas supply region are large, the difference in distance to the gas outlets 26 is large between the gas channels 15 located closest to the periphery of the shower plate 11 and the gas channels 15 located at the center of the shower plate 11, and so is the difference in gas supply rate. These are issues which should be addressed.

Accordingly, in the vapor deposition apparatus 1A in accordance with the present embodiment, the gas distribution space 13 is formed in a hat-like shape, thereby restraining the gas supply ratesfrom the gas channels 15 located right under the second space 132 where the gas supply rates are likely to be affected by the discharge gas flow to the gas outlets 26. As a result, the vapor deposition apparatus 1A makes it possible to supply uniform gas amountsfrom the gas channels 15 in the gas supply region.

### [Embodiment 2]

The following will describe another embodiment of the present invention in reference to Figs. 3 to 8. The configuration of the present embodiment is the same as the configuration of embodiment 1 unless otherwise specified. In addition, for convenience in description, members having the same functions as those shown in the drawings for embodiment 1 are given the same numerals/symbols, and their description is omitted.

A vapor deposition apparatus 1B in accordance with the present embodiment is described in reference to Fig. 3. Fig. 3 is a cross-sectional view of the configuration of the vapor deposition apparatus 1B in accordance with the present embodiment.

The vapor deposition apparatus 1B in accordance with the present embodiment, as illustrated in Fig. 3, differs from the vapor deposition apparatus 1A in that a shower head 10 is provided with a diffusion plate 50 which divides a gas distribution space 13 into two spaces, an upstream space and a downstream space.

In other words, the shower head 10 of the vapor deposition apparatus 1B, as illustrated in Fig. 3, includes a third space 133 (as the upstream space) and the diffusion plate 50. The third space 133. located on the gas inlets 14 side of the first space 131, is for uniformly mixing a plurality of introduced source gases so as to achieve a uniform mix ratio. The diffusion plate 50 separates the first space 131 (as the downstream space) from the third space 133 and allows the source gases introduced to the third space 133 to flow to the first space 131 through diffusion holes 51 formed through the diffusion plate 50.

The third space 133 is formed in a columnar shape which has a large enough diameter to dispose the gas inlets 14 located closest to the periphery within the diameter so that the source gases introduced through the gas inlets 14 are collectively mixed.

Next, the configuration of diffusion plate 50 is described in detail in accordance with Fig. 4. Fig. 4 is a plan view illustrating the configuration of the diffusion plate 50 which separates the first space 131 and the third space 133.

The diffusion plate 50 has, as illustrated in Fig. 4, the diffusion holes 51 through which the introduced source gases can flow from the third space 133 to the first space 131. If the diffusion holes 51 are formed across the diffusion plate 50, there may occur a gas flow shunted from the diffusion holes 51 along the periphery of the diffusion plate 50 to the gas channels 15 along the periphery of the shower plate 11 under the effect of the gas outlets 26.

Accordingly, in the present embodiment, the diffusion holes 51 are formed only in a central part (gas flow region) of the diffusion plate 50 as illustrated in Fig. 4. The gas flow region, which is a part of the diffusion plate 50 where the diffusion holes 51 are formed, is inside a circle which has a smaller diameter than the diameter of the circular, horizontal cross-section of the third space 133.

According to the configuration, the diffusion plate 50 has no diffusion holes 51 along its periphery. The gas flow to the gas channels 15 along the periphery of the shower plate 11 is therefore restricted. Meanwhile, the gas passing through the gas flow region in the central part of the diffusion plate 50 is likely to flow to the gas channels 15 near the center of the shower plate 11. As a result, the gas can be fed to the gas channels 15 of the shower plate 11 at uniform gas supply rates, respectively.

To restrict passage of gas along the periphery of the diffusion plate 50, for example, the diffusion holes 51 may be distributed more toward the central part of the diffusion plate 50 from the periphery of the diffusion plate 50, or the diffusion holes 51 may become larger in diameter toward the central part from the periphery.

As described above, in the vapor deposition apparatus 1B in accordance with the present embodiment, the gas distribution space 13 is formed in a hat-like shape, and the third space 133 and the diffusion plate 50 are provided, so that the gas distribution space 13 can be divided into three spaces (stages) and an upstream gas passage region is narrowed down to the central part. The configuration therefore restrains the gas supply ratesfrom those gas channels 15, of the shower plate 11, which are located right under the second space 132 (these gas supply rates are likely to be affected by the discharge gas flow to the gas outlets 26) and thereby makes it possible to supply the gas uniformly in amountfrom the gas channels 15 in the gas supply region of the shower plate 11.

The following will describe gas flow rate distribution simulation for the vapor deposition apparatus 1B in accordance with the present embodiment in comparison with gas flow rate distribution simulation for a conventional vapor deposition apparatus 200 in reference to (A) and (B) of Fig. 5, (A) and (B) of Fig. 6, and Fig. 7. (A) and (B) of Fig. 5 are respectively a plan view and a cross-sectional view illustrating a gas flow rate distribution simulation model for the vapor deposition apparatus 1 B in accordance with the present embodiment. (A) and (B) of Fig. 6 are respectively a plan view and a cross-sectional view illustrating a gas flow rate distribution simulation model for the conventional vapor deposition apparatus 200. Fig. 7 is a graphical representation of a simulated distribution of gas flow rate from the gas channels 15 in the vapor deposition apparatus 1B in accordance with the present embodiment, in comparison with a simulated distribution of gas flow rate from gas channels 215 in the conventional vapor deposition apparatus 200.

As illustrated in (A) and (B) of Fig. 5, a 1/8π-model of the vapor deposition apparatus 1B is used in the gas flow rate distribution simulation for the vapor deposition apparatus 1B in accordance with the present embodiment. The model has a total of five gas inlets 14, one of which is at the center of the top face of a shower head 10 whilst the remaining four are at four respective positions which lie on a circumference centered at the center of the top face with a radius of 100 mm and which are also separated from each other by equal distances. The 1/8π-model of the vapor deposition apparatus 1B in accordance with the present embodiment is provided with a gas distribution space 13, of a hat-like shape, which includes a first space 131 having a diameter (ϕ) (measured to the side wall) of 420 mm and a second space 132 having a diameter (ϕ) (measured to the side wall) of 570 mm.

In the 1/8π-model of the vapor deposition apparatus 1 B in accordance with the present embodiment, gas channels 15 (ϕ = 1 mm) are also formed at 5-mm intervals in a gas supply region (ϕ = 570 mm) of a shower plate 11.

The gas distribution space 13 of a hat-like shape, provided in the shower head 10, shares the same central axis with the first space 131 and the second space 132. The first space 131 has a columnar shape and measures 25 mm in height and 420 mm in diameter (ϕ). The second space 132, located below the first space 131, has a columnar shape and measures 3 mm in height and 570 mm in diameter (ϕ).

Above the hat-shaped gas distribution space 13 is there provided a diffusion plate 50 which separates the third space 133 from the second space 132. The diffusion plate 50 has a columnar shape and measures 5 mm in height and 570 mm in diameter (ϕ).

A gas flow region of the diffusion plate 50, which has the same diameter of 420 mm as the first space 131, has, at 5-mm intervals, diffusion holes 51 (ϕ = 2 mm) through which the source gases introduced to the third space 133 can flow to the first space 131.

In contrast, as illustrated in (A) of Fig. 6, a 1/8π-model of the vapor deposition apparatus 200 is used in the gas flow rate distribution simulation for the conventional vapor deposition apparatus 200. The model has a total of five gas inlets 214, one of which is at the center of the top face of a shower head 210 whilst the remaining four are at four respective positions which lie on a circumference centered at the center of the shower head 210 with a radius of 100 mm and which are also separated from each other by equal distances. The model of the conventional apparatus is provided with a columnar gas distribution space 213 having a diameter (ϕ) (measured to the side wall) of 570 mm.

In the conventional vapor deposition apparatus 200, the gas channels 215 (ϕ = 1 mm) are formed at 5-mm intervals in a gas supply region (ϕ = 570 mm) of a shower plate 211 as illustrated in (B) of Fig. 6. The columnar gas distribution space 213, provided in the shower head 210, measures 25 mm in height and 570 mm in diameter (ϕ).

Simulated gas flow rate distributions obtained using the models are represented in Fig. 7. In Fig. 7, the gas flow rate distribution obtained from simulation of the gas flow rate from the gas channels 15 using the 1/8π-model of the vapor deposition apparatus 1B in accordance with the present embodiment is indicated by a solid line. The gas flow rate distribution obtained from simulation of the gas flow rate from the gas channels 215 using the 1/8π-model of the conventional vapor deposition apparatus 200 is indicated by a broken line.

Also in Fig. 7, the horizontal axis represents the distance (mm) from the center of the shower head to the individual gas channels, and the vertical axis represents the gas flow rate from the gas channels. The numeric values for the gas flow rate are given relative to the gas flow rate from the gas channel 215 located 200 mm away from the center of the shower head 210 of the 1/8π-model of the conventional vapor deposition apparatus 200.

Referring to Fig. 7, in the 1/8π-model of the vapor deposition apparatus 1B in accordance with the present embodiment, the increase in gas flow rate is restrained starting near the boundary, between the first space 131 and the second space 132, which is about 210 mm away from the center of the shower head 10. As a result, the gas flow rate from the gas channels 15 located 125 mm to 275 mm away from the center of the shower head 10 exhibits a rate of change (= ((Maximum - Minimum) / Mean Value) × 100) of about Δ2.3%

In contrast, in the 1/8π-model of the conventional vapor deposition apparatus 200, the gas flow rate increases linearly farther away from the center of the shower head 210 where the rate is relatively unlikely to be affected by the discharge gas flow toward the gas outlets 226 to the periphery where the rate is relatively likely to be affected by the discharge gas flow to the gas outlets 226. As a result, the gas flow rate from the gas channels 215 located 125 mm to 275 mm away from the center of the shower head 210 exhibits a rate of change (= ((Maximum - Minimum) / Mean Value) × 100) of about Δ5.7%.

As witnessed above, in the vapor deposition apparatus 1B in accordance with the present embodiment, the gas flow rates from those gas channels 15 close to the gas outlets 26 of the shower plate 11 and the gas flow rates from those gas channels 15 far from the gas outlets 26 of the shower plate 11 are made practically equal to each other by forming the gas distribution space 13 having a hat-like shape in which the source gas introduced through the gas inlets 14 is uniformly and broadly diffused. In other words, the gas is supplied uniformly in amount on the surface of the target substrate 31 in the reaction chamber 21 by means of the structural shape of the gas distribution space 13. This in turn improves quality of the film formed on the target substrate 31 in terms of its thickness, composition ratio, etc. Hence, the embodiment can provide a vapor deposition apparatus 1B at low design and assembly cost.

The aforementioned embodiment should be regarded as illustrative, not restrictive. Specifically, in the description above, the diffusion plate 50 is provided in an upper part of the hat-shaped gas distribution space 13 in the vapor deposition apparatus 1B so that the gas passage region is narrowed down farther upstream. Therefore, the shape of the gas distribution space 13 is not limited to this provided that the gas passage region is narrowed down farther upstream. The gas distribution space 13 may take a different shape. For example, the gas distribution space 13 of the vapor deposition apparatus 1B in accordance with the present embodiment may take a shape determined according to the positions of the gas outlets 26, the diameter(s) of the gas channels 15, the intervals between the gas channels 15, etc.

In this viewpoint, (A), (B), and (C) of Fig. 8 illustrate exemplary cross-sectional shapes of the gas distribution space 13 applicable to the vapor deposition apparatus 1 B in accordance with the present embodiment. (A) and (B) of Figs. 8 illustrate shapes of a gas distribution space 13 applicable to a vapor deposition apparatus in which gas outlets 26 are provided in a side wall of a reactor 20. (C) of Fig. 8 illustrates a shape of a gas distribution space 13 applicable to a vapor deposition apparatus in which gas outlets 26 are provided at the center of the bottom face of a reactor 20.

The gas distribution space 13 illustrated in (A) of Fig. 8 includes a second space 132 whose height decreases in steps toward the side wall.

The gas distribution space 13 illustrated in (B) of Fig. 8 includes a second space 132 whose height decreases linearly toward the side wall.

The gas distribution space 13 illustrated in (C) of Fig. 8 includes a first space 131 near the periphery of the gas distribution space 13 and a second space 132, near its center, whose height is lower than that of the first space 131 as a result of a gas outlet 26 being provided at the center of the bottom face of a reactor 20.

The variations described in reference to (A) to (C) of Fig. 8 are, needless to say, included within the scope of the present invention.

### [Embodiment 3]

The following will describe a further embodiment of the present invention in reference to Figs. 9 to 13. The configuration of the present embodiment is the same as the configurations of embodiments 1 and 2 unless otherwise specified. In addition, for convenience in description, members having the same functions as those shown in the drawings for embodiments 1 and 2 are given the same numerals/ symbols, and their description is omitted.

A vapor deposition apparatus in accordance with the present embodiment is described in reference to Fig. 9. Fig. 9 is a cross-sectional view of a schematic configuration of a shower head 10A in the vapor deposition apparatus in accordance with the present embodiment.

The shower head 10A in accordance with the present embodiment differs from the shower head 10 in the vapor deposition apparatus 1A or the vapor deposition apparatus 1B in that an adjustment mechanism is provided which is capable of adjusting the height of a ceiling face from a floor face of a second space 132.

In other words, as illustrated in Fig. 9, the shower head 10A in accordance with the present embodiment includes: a shower plate 11; a distribution space forming mechanism 12 coupled to the shower plate 11 as an upper layer member for the shower plate 11; and an introduction space forming mechanism 125, coupled to the distribution space forming mechanism 12 as an upper layer member for the distribution space forming mechanism 12, for forming a third space 133.

The distribution space forming mechanism 12 includes a second space forming mechanism 122 and a first space forming mechanism 121. The second space forming mechanism 122 constitutes the second space 132 or a part of the second space 132, whereas the first space forming mechanism 121, by being coupled to the second space forming mechanism 122 as an upper layer member for the second space forming mechanism 122. constitutes a first space 131. The first space forming mechanism 121 is configured so that a diffusion plate 50 can be attached to it.

A concrete example of the distribution space forming mechanism 12 in the shower head 10A is described in reference to Fig. 10. Fig. 10 is an exploded perspective view illustrating the configuration of a first group of members in the shower head 10A.

The shower head 10A, as illustrated in Fig. 10, may be include a shower plate 11a, a distribution space forming mechanism 12a, and an introduction space forming mechanism (not shown).

The shower plate 11a is a columnar member. On the top of the shower plate 11a is there formed a concave face including a circular region, with a diameter of R2, which is lower in height than the periphery by H3. The shower plate 11a has a plurality of gas channels 15 extending from the concave face to the bottom face.

The distribution space forming mechanism 12a is constituted by either a first space forming member 121a or the first space forming member 121 a and at least one second space forming member 122a (as a second space-height adjusting member). The first space forming member 121a is of a cylindrical shape and has formed therein a hole with a diameter of R1 and a height of H1.

The second space forming member 122a is of a ring shape and has formed therein a hole with a diameter of R2 and a height of H2.

The first space forming member 121a is configured so that the diffusion plate 50, provided with a plurality of diffusion holes 51, can be attachable onto it within the R1 (diameter) region.

These members are configured so that they can be coupled together by aligning the central axes of their cylindrical or columnar shapes.

When the distribution space forming mechanism 12 includes only the first space forming member 121a, as illustrated in (A) of Fig. 11, the second space 132 has a height equal to the height H3 of the space formed by the concave face of the shower plate 11a.

In contrast, when the distribution space forming mechanism 12 is constituted by the first space forming member 121a and one second space forming member 122a, as illustrated in (B) of Fig. 11, the second space 132 has a height equal to the sum of the height H2 of the space formed by incorporating the second space forming member 122a as a structural member and the height H3 of the space formed by the concave face of the shower plate 11a.

In this manner, in the present embodiment, the height of the second space 132 is adjustable by means of the number of second space forming members 122a used.

Next, another concrete example of the distribution space forming mechanism 12 in the shower head 10A is described in reference to Fig. 12. Fig. 12 is an exploded perspective view illustrating the configuration in the shower head 10A of a second group of members which differs from the first group of members.

The shower head 10A, as illustrated in Fig. 12, may include a shower plate 11b, a distribution space forming mechanism 12b, and an introduction space forming mechanism (not shown).

The shower plate 11b includes a columnar member. The shower plate 11b is holed, in a central part (ϕ = R4) thereof, by a plurality of gas channels 15 extending from the top face to the bottom face thereof.

The distribution space forming mechanism 12b, provided as an upper layer member for the shower plate 11b, includes: a cylindrical first space forming member 121b which has formed therein a hole with a diameter of R1 and a height of H1; and a second space forming member 122b (as a second space-height adjusting member) which has a hole with a diameter of R4 and which also has a bellows structure capable of adjusting its height in the range of H5 (minimum) to H4 (maximum).

The first space forming member 121b is configured so that a diffusion plate 50, provided with a plurality of diffusion holes 51, can be attached to it within the R1 (diameter) region.

These members are configured so that they can be coupled together by aligning the central axes of their cylindrical or columnar shapes.

(A) and (B) of Fig. 13 are cross-sectional views illustrating the configuration of a second space 132 formed by the second group of members in the vapor deposition apparatus.

As illustrated in (A) of Fig. 13, for example, if the vapor deposition apparatus is assembled by adjusting the height of the second space forming member 122b to a maximum available height, the height of the second space 132 is equal to H4.

In contrast, for example, as illustrated in (B) of Fig. 13, if the vapor deposition apparatus is assembled by adjusting the height of the second space forming member 122b to a minimum available height, the height of the second space 132 is equal to H5.

As a result, in the shower head 10A in accordance with the present embodiment, the height of the second space 132 can be adjusted by suitably adjusting the height of the second space forming member 122b during the assembly of the vapor deposition apparatus.

In this manner, in the vapor deposition apparatus in accordance with the present embodiment, the height(s) of the first space 131, the second space 132, or both is/are configured to be adjustable. This configuration enables suitable adjustment of the height of the first space 131 or the second space 132, for example, according to the species or mix ratio of the gases introduced, and hence more elaborate optimization of the gas supply ratesfrom gas channels 15.

### [Embodiment 4]

The following will describe yet another embodiment of the present invention in reference to Fig. 14. The configuration of the present embodiment is the same as the configurations of embodiments 1 to 3 unless otherwise specified. In addition, for convenience in description, members having the same functions as those shown in the drawings for embodiments 1 to 3 are given the same numerals/ symbols, and their description is omitted.

A vapor deposition apparatus in accordance with the present embodiment is described in reference to Fig. 14. Fig. 14 is a cross-sectional view of a schematic configuration of a shower head 10B the vapor deposition apparatus in accordance with the present embodiment.

The shower head 10B in accordance with the present embodiment differs from the shower head 10A described in embodiment 3 in that an adjustment mechanism is provided which is capable of adjusting the height of a first space 131.

The shower head 10B, as illustrated in Fig. 14, includes: a shower plate 11; a distribution space forming mechanism 12c coupled to the shower plate 11 as an upper layer member for the shower plate 11; and an introduction space forming mechanism 125, coupled to the distribution space forming mechanism 12c as an upper layer member for the distribution space forming mechanism 12c, for forming the third space 133.

The distribution space forming mechanism 12c includes a second space forming mechanism 122 and a first space forming member 121c. The second space forming mechanism 122 constitutes a second space 132 or a part of the second space 132, whereas the first space forming member 121c constitutes the first space 131.

The first space forming member 121c, provided with a hole of a predetermined diameter, has a bellows structure capable of adjusting its height in the range of H7 (minimum) to H6 (maximum). The first space forming member 121c is configured so that a diffusion plate 50, provided with a plurality of diffusion holes 51, can be attached to it.

These members are configured so that they can be coupled together by aligning the central axes of their cylindrical or columnar shapes.

As a result, in the shower head 10B in accordance with the present embodiment, the height of the first space 131 can be adjusted by suitably adjusting the height of the first space forming member 121c during the assembly of the vapor deposition apparatus.

In this manner, in the vapor deposition apparatus in accordance with the present embodiment, the height(s) of the first space 131, the second space 132, or both is/are configured to be adjustable. This configuration enables suitable adjustment of the height of the first space 131 or the second space 132, for example, according to the species or mix ratio of the gases introduced, and hence more elaborate optimization of the gas supply ratesfrom gas channels 15.

The embodiments disclosed here are illuminative, and by no means restrictive, in every respect. The scope of the present invention is set forth only by patent claims, not by the description above, and encompasses all variations within the meaning and scope of the equivalents of the patent claims.

As described in the foregoing, in the vapor deposition apparatus in accordance with the present invention, the shower head includes a diffusion plate which divides a gas distribution space into two spaces, one of which is an upstream space and the other one of which is a downstream space. Furthermore, the diffusion plate has a plurality of diffusion holes for allowing the gas to pass from the upstream space to the downstream space through the holes.

In addition, in the vapor deposition apparatus in accordance with the present invention, the shower head includes a second space-height adjusting mechanism for adjusting the height of the second space.

In addition, in the vapor deposition apparatus in accordance with the present invention, the shower head includes a first space-height adjusting mechanism for adjusting the height of the first space.

### Industrial Applicability

The present invention is applicable to vapor deposition apparatus, such as a vertical-type MOCVD apparatus which supplies a gas to the surface of a target substrate through a plurality of gas channels of a shower plate in a shower head.

### Reference Signs List

| | |
|---|---|
| 1A, 1B | Vapor Deposition Apparatus |
| 10 | Shower Head |
| 10A | Shower Head |
| 10B | Shower Head |
| 11 | Shower Plate |
| 11a | Shower Plate |
| 12 | Distribution Space Forming Mechanism |
| 12a, 12b, 12c | Distribution Space Forming Mechanism |
| 13 | Gas Distribution Space |
| 14 | Gas Inlet |
| 15 | Gas Channel |
| 18 | Cooling Medium Channel |
| 20 | Reactor |
| 21 | Reaction Chamber |
| 25 | Gas Discharge Section |
| 26 | Gas Outlet |
| 30 | Substrate Support |
| 31 | Target Substrate |
| 32 | Rotation Axis |
| 33 | Heater |
| 50 | Diffusion Plate |
| 51 | Diffusion Hole |
| 121 | First Space Forming Mechanism |
| 121a, 121b, 121c | First Space Forming Member (First Space-height Adjusting Member) |
| 122 | Second Space Forming Mechanism |
| 122a, 122b | Second Space Forming Member (Second Space-height Adjusting Member) |
| 125 | Introduction Space Forming Mechanism |
| 131 | First Space (Downstream Space) |
| 132 | Second Space |
| 133 | Third Space (Upstream Space) |

## Claims

1. A vapor deposition apparatus, comprising:
a reactor for housing a target substrate on which a thin film is to be formed by vapor deposition;
a shower head having:
a gas inlet for introducing a gas;
a gas distribution space for diffusing the gas; and
a shower plate having a plurality of gas channels for supplying the gas from the gas distribution space into the reactor; and
a gas outlet for externally discharging the gas from the reactor,
the gas distribution space of the shower head having the shower plate as a bottom face thereof,
the gas distribution space having a first space and a second space, the first space being farther from the gas outlet of the reactor than is the second space,
the first space being formed so as to be taller than the second space.

2. The vapor deposition apparatus as set forth in claim 1, wherein:
the shower head includes a diffusion plate which divides the gas distribution space into two spaces, one of which is an upstream space and the other one of which is a downstream space; and
the diffusion plate has a plurality of diffusion holes for allowing the gas to pass from the upstream space to the downstream space through the holes.

3. The vapor deposition apparatus as set forth in claim 1 or 2, wherein the shower head includes a second space-height adjusting member for adjusting a height of the second space.

4. The vapor deposition apparatus as set forth in claim 1 or 2, wherein the shower head includes a first space-height adjusting member for adjusting a height of the first space.
